# EUROPÄISCHE PATENTSCHRIFT

(11) **EP 0 965 047 B1**
(45) Veröffentlichungstag und Bekanntmachung des Hinweises auf die Patenterteilung: **19.09.2001**
(21) Anmeldenummer: 98914808.5
(22) Anmeldetag: 23.02.1998
(51) Int. Cl.: G01R 31/34

(54) **VERFAHREN UND VORRICHTUNG ZUR IDENTIFIKATION DER SYSTEMPARAMETER STATORWIDERSTAND UND ROTORWIDERSTAND EINER GEBERLOSEN, FELDORIENTIERT BETRIEBENEN DREHFELDMASCHINE**
METHOD AND DEVICE FOR IDENTIFYING THE SYSTEM PARAMETERS STATOR RESISTANCE AND ROTOR RESISTANCE OF A TRANSMITTER-FREE INDUCTION MACHINE OPERATED IN A FIELD-ORIENTED MANNER
PROCEDE ET DISPOSITIF POUR IDENTIFIER LES PARAMETRES DE SYSTEME, A SAVOIR RESISTANCE DU STATOR ET RESISTANCE DU ROTOR, D'UNE MACHINE POLYPHASEE SANS CAPTEUR, A ORIENTATION DE CHAMP

(30) Priorität: 06.03.1997 DE 19709296
(43) Veröffentlichungstag der Anmeldung: 22.12.1999
(73) Patentinhaber: SIEMENS AKTIENGESELLSCHAFT, 80333 München (DE)
(72) Erfinder: DEPENBROCK, Manfred, D-44797 Bochum (DE); HOFFMANN, Frank, D-91315 Höchstadt (DE)
(86) Internationale Anmeldenummer: DE9800536
(87) Internationale Veröffentlichungsnummer: WO9839663

(56) Entgegenhaltungen:
- DE-A- 19 531 771
- US-A- 4 441 065
- US-A- 4 884 023
- LEE,HAA,YOO: "An on-line identification method for both stator and rotor resistances of induction motors without rotational transducers." PROCEEDINGS OF THE IEEE INTERNTATIONAL SYMPOSIUM ON INDUSTRIAL ELECTRONICS, Bd. 1, 17. - 20.Juni 1996, WARSAW, Seiten 325-330, XP002072570

## Beschreibung

Die Erfindung bezieht sich auf ein Verfahren zur Identifikation der Systemparameter Statorwiderstand und Rotorwiderstand einer geberlosen, feldorientiert betriebenen Drehfeldmaschine, insbesondere einer Traktions-Drehfeldmaschine, wobei beim Stillstand der aufmagnetisierten Drehfeldmaschine dieses Verfahren durchgeführt wird und auf eine Vorrichtung zur Durchführung des Verfahrens.

Für den Betrieb einer geberlosen, feldorientiert betriebenen Drehfeldmaschine ist es unausweichlich neben einer Modellierung des benutzten Pulsumrichters die Drehfeldmaschine sehr genau zu beschreiben. Die in einem Ersatzschaltbild zur Modellierung der Drehfeldmaschine benötigten Parameter müssen betriebspunkt- sowie temperaturabhängig nachgeführt werden. Die Betriebspunktabhängigkeit der Streu- und Hauptinduktivität kann dabei ausreichend exakt durch eine Offline-Messung ermittelt werden. Dabei kann die Stromabhängigkeit der Streuinduktivität für viele Drehfeldmaschinen vernachlässigt werden, so daß die Streuinduktivität bei vernachlässigbar kleinen Fehlern als konstant angenommen werden kann. Die Hauptinduktivität der Drehfeldmaschine hängt vom Sättigungszustand der Maschine ab, der im quasi-stationären Betrieb eindeutig durch zwei Zustandsgrößen beschreibbar ist. Es ist sinnvoll, den Sättigungszustand der Maschine durch den Betrag der Grundschwingungsraumzeiger von Statorfluß und Statorstrom zu beschreiben, da der Statorstrom meßtechnisch leicht und genau ermittelt werden kann und der Statorfluß bei exaktem Statorwiderstand und genauen Pulsstromrichtermodell mathematisch einfach bestimmt werden kann. Die beschriebene Abhängigkeit kann in einer Offline-Messung ermittelt und auf einem Signalprozessor auf einfache Art und Weise digital nachgebildet werden.

Die Temperaturabhängigkeit des Stator- und des Rotorwiderstandes muß jedoch Online berücksichtigt werden. Im Hochleistungsbereich wird in der Traktion dabei normalerweise die Temperatur der Statorwicklungen meßtechnisch erfaßt. Die Temperaturmessung ist jedoch recht fehleranfällig und je nach Anordnung der Meßelemente recht ungenau, so daß es wünschenswert ist, den Stator- und Rotorwiderstand in allen Betriebsbereichen auf andere Weise ausreichend genau zu identifizieren.

Im unteren und im mittleren Leistungsbereich der Traktionstechnik (Nahverkehr) wird auf eine Temperaturmessung völlig verzichtet, so daß hier die aktuellen Widerstandswerte nicht bekannt sind. Der Statorwiderstand wird in der Regel auch nicht auf andere Weise ermittelt, was außerhalb des Anfahrbereichs auch keine nennenswerten Auswirkungen hat. Die Identifikation des Rotorwiderstandes wird üblicherweise erst ab einer Frequenz von etwa 5 Hz durchgeführt. Dabei ist es jedoch gerade im Anfahrbereich wichtig, die beiden Widerstände recht genau zu kennen, da ansonsten die geforderte Zugkraft von der Maschinenregelung nicht genau eingestellt werden kann. Außerdem ist ein geberloser Betrieb einer feldorientiert betriebenen Drehfeldmaschine bei kleinen Statorfrequenzen bis hin zur Frequenz Null nur möglich, wenn der Statorwiderstand recht genau bekannt ist. Um bei Verzicht auf einen Drehzahlgeber die Drehzahl selber möglichst genau zu identifizieren und das geforderte Drehmoment möglichst gut einstellen zu können, ist auch die Kenntnis des Rotorwiderstandes erforderlich.

Der Rotorwiderstand kann beispielsweise auf der Grundlage des Primärstromes, der Schlupffrequenz, der Klemmenspannung und dgl. abgeleitet werden. Diese Ermittlung ist wirksam bei der Ausführung einer genauen Motordrehzahlsteuerung, solange der Asynchronmotor unter stabilen Bedingungen kontinuierlich angetrieben wird. In solchen Fällen allerdings, in denen die Belastung des Asynchronmotors sich häufig ändert und ungeachtet von Temperaturbedingungen gleichmäßige Beschleunigungs- und Verzögerungswerte erforderlich sind, kann dieses Verfahren keine zufriedenstellenden Ansprechkennwerte liefern. Um eine zufriedenstellend hohe Ansprechgeschwindigkeit auf Änderungen des Sekundärwiderstandes zu erhalten, ist es notwendig, einen Wärmefühler oder dergleichen vorzusehen.

Im Aufsatz "Bald Normalität - Entwicklungsstand und Tendenzen bei selbsteinstellenden Reglern für asynchrone Drehstromantriebe", abgedruckt in der DE-Zeitschrift "Maschinenmarkt", Würzburg 98 (1992), Nr. 5, Seiten 52 bis 56, werden verschiedene Möglichkeiten aufgezeigt, wie die Motorparameter Ständer- und Läuferwiderstand, totale Streuinduktivität und Hauptinduktivität bestimmt werden können. Diese Motorparameter werden bei der Selbsteinstellung - eine Hilfe zur Inbetriebnahme, die die Parameter und Reglerkoeffizienten bei der Inbetriebnahme selbständig an einen angeschlossenen Motor anpaßt - ermittelt. Zum Bestimmen dieser Parameter kann man einerseits diese aus den Typenschilddaten berechnen und andererseits existieren verschiedene Meßverfahren, die in der Tafel 1 dieses Aufsatzes aufgeführt sind. Allen Verfahren ist gemeinsam, daß die Motorimpedanzen aus der Analyse der Zusammenhänge zwischen Strom und Spannung an den Ausgangsklemmen des Umrichters ermittelt werden. Weil der Umrichter in der Regel nicht mit Spannungsmeßgliedern ausgestattet ist, wird die Klemmenspannung aus der Sollspannung des Steuersatzes abgeleitet. Mit einer Gleichstrommessung läßt sich aus dem Verhältnis zwischen Spannung und Strom im eingeschwungenen Zustand der Ständerwiderstand einfach und zuverlässig ermitteln. Die Ergebnisse sind sehr genau, wenn man die nichtidealen Eigenschaften des Umrichters (Verriegelungszeit, Ventilspannungsabfall) korrigiert. Mittels einer Kurzschlußmessung wird aus dem Verhältnis zwischen Spannungs- und Stromamplitude der Parameter Streureaktanz ermittelt. Wenn der Umrichter den Strommeßwert in Wirkstrom und Blindstrom aufteilen kann, läßt sich aus einer bestimmten Wirkleistung auch ein Summenwiderstand aus Ständer- und Läuferwiderstand ermitteln, so daß mit bekanntem Ständerwiderstand auch der Läuferwiderstand ermittelt ist. Mittels der Leerlaufmessung und ermittelter Spannungs- und Stromamplituden läßt sich die Ständerreaktanz ermitteln.

Die größte Schwierigkeit dieser Leerlaufmessung liegt in der Steuerung des Ablaufs. Außerdem ist beispielsweise im Bereich der Hebezeuge das Durchführen der Leerlaufmessung sehr schwierig, weil der Antrieb nur kurze Zeit mit konstanter Drehzahl laufen kann.

Aus dem Aufsatz "Selbstinbetriebnahme - eine neue Eigenschaft moderner Drehstromantriebe", abgedruckt in der DE-Zeitschrift "Automatisierungstechnische Praxis atp", Band 32 (1990), Nr. 7, Seiten 372 bis 376, ist ein weiteres Meßverfahren zur Identifikation von Motorparametern bekannt, das ohne Umrichter überhaupt nicht denkbar wäre. Bei diesem Meßverfahren werden die Motorimpedanzen aus dem dynamischen Verhalten des Motorstroms bei Speisung mit veränderlicher Gleichspannung im Stillstand bestimmt. Bei der Stillstandsmessung wird die Streuinduktivität des Motors im wesentlichen aus der Reaktion auf sehr schnelle Spannungsänderungen, der Läuferwiderstand und die Hauptinduktivität aus der Reaktion auf langsame Änderungen bestimmt. Die Gleichstrommessung zum Bestimmen des Ständerwiderstandes ist in diesem Meßverfahren integriert. Der gesamte Vorgang dieses Meßverfahrens dauert nur wenige Sekunden.

Aus der EP 0 313 671 B1 ist eine weitere Methode zur Erfassung der Motorparameter Primärwiderstand und Sekundärwiderstand bekannt. Bei diesem Identifizierungsverfahren wird im Stillstand der Primärwiderstand auf der Grundlage des Primärstromes und der Primärspannung berechnet. Der Sekundärwiderstand wird auf der Grundlage des Primärwiderstandes ermittelt. Dazu wird angenommen, daß im Fall von Asynchronmotoren großer Kapazität, wie sie zum Antreiben eines Aufzugs-Fahrkorbes entworfen werden, die temperaturabhängigen Änderungen der Primär- und Sekundärwiderstände in der Primär- bzw. Sekundärwicklung einander proportional sind. Durch Ableiten der temperaturabhängigen Änderung des Primärwiderstandes läßt sich also die temperaturabhängige Änderung des Sekundärwiderstandes auf der Grundlage des abgeleiteten Primärwiderstandes projizieren. Dabei wird der Primärstrom auf einen fixen Wert eingestellt und die Änderung der Primärspannung zu einer Referenz-Primärspannung ermittelt. Mit dieser Änderung wird ein Referenz-Sekundärwiderstand multipliziert, so daß man mittels dieser einfachen arithmetischen Operation den projizierten Sekundärwiderstand erhält. Da dieser projizierte Sekundärwiderstand während der vorläufigen Erregung des Asynchronmotors, abgeleitet werden kann, kann mit dem Start des Asynchronmotors die Identifizierung beginnen.

Voraussetzung für diese Identifizierungsmethode ist, daß ein Referenz-Sekundärwiderstand und eine Referenz-Primärspannung Offline bestimmt werden muß. Das heißt, bei einer Referenz-Temperatur muß der Referenz-Sekundärwiderstand und die Referenz-Spannung gemessen werden. Außerdem wird der temperaturveränderliche Sekundärwiderstand mittels einer Spannungsmessung ermittelt. Wie eingangs erwähnt, weisen Umrichter in der Regel keine Spannungsmeßglieder auf.

Aus dem US-Patent 4,884,023 ist ein weiteres Verfahren und eine Vorrichtung zur Bestimmung des Läuferwiderstandes einer Drehfeldmaschine bekannt. Bei diesem Verfahren wird im Ständer über eine feldorientierte Regelung Strom eingeprägt, der in Richtung des Flusses einen harmonischen über der Nennfrequenz der Maschine liegenden Anteil besitzt (Testsignal). Aus Strom, Läuferlage und einen nachstellbaren Parameterwert für den Läuferwiderstand rechnet ein Strommodell eine feldparallele EMK-Komponente aus, deren harmonischer Anteil isoliert wird. Zusätzlich rechnet aus Strom und Spannung ein Spannungsmodell eine feldparallele Komponente des EMK-Vektors als Stromkomponenten-Sollwert und deren harmonischen Anteil aus. Ein Korrekturregler stellt den Parameter des Läuferwiderstandes solange nach, bis die Differenz beider isolierter harmonischer EMK-Anteile verschwindet. Das Testsignal wirkt sich praktisch nicht im Fluß und Drehmoment der Drehfeldmaschine aus.

Der Erfindung liegt nun die Aufgabe zugrunde, ein Verfahren zur Identifikation von Systemparametern Statorwiderstand und Rotorwiderstand einer geberlosen, feldorientiert betriebenen Drehfeldmaschine anzugeben, das insbesondere in der Traktion eingesetzt werden kann.

Diese Aufgabe wird durch die Merkmale des Anspruchs 1 erfindungsgemäß gelöst.

Bei diesem erfindungsgemäßen Verfahren wird beim Stillstand der aufmagnetisierten Drehfeldmaschine zunächst eine Gleichspannung in die Drehfeldmaschine eingespeist und ein Gleichstrom-Istwert ermittelt. Mittels dieser beiden Werte, gemittelt über ein Modulationsspiel, wird der Statorwiderstand berechnet. Anschließend wird ein vorbestimmtes Drehmoment aufgeschaltet und ein aus gemessenen Statorströmen ermittelter Statorstrom-Istraumzeiger ermittelt und ein berechneter Statorstrom-Modellraumzeiger in ein feldorientiertes komplexes Bezugssystem mittels eines konjugiert komplexen Bezugsraumzeigers transformiert. Anschließend werden diese transformierten Statorstrom-Ist- und Modellraumzeiger jeweils in einen Real- und Imaginärteil aufgespalten. Mit Hilfe dieser Imaginäranteile dieser transformierten Statorstrom-Ist- und Modellraumzeiger wird eine Regelabweichung ermittelt. Existiert eine Regelabweichung, so ist der Rotorwiderstand noch nicht exakt bestimmt. Die Höhe dieser Regelabweichung ist ein Maß für die fehlerhafte Bestimmung des Rotorwiderstandes. Dadurch, daß diese Regelabweichung mittels eines Reglers zu Null geregelt wird, erhält man den wahren Wert des Rotorwiderstandes.

Somit kann durch Aufschaltung eines vorbestimmten Drehmomentwertes und Auswertung eines Statorstrom-Istraumzeigers und eines Statorstrom-Modellraumzeigers ein Maß für die Abweichung eines Modell-Rotorwiderstandes vom Rotorwiderstand der Drehfeldmaschine ermittelt und abgestimmt werden. Mit diesen erfindungsgemäßen Verfahren werden der Statorwiderstand und der Rotorwiderstand innerhalb einer kurzen Zeit (weniger als eine Sekunde) beim Stillstand der Drehfeldmaschine identifiziert.

Bei der Parameterermittlung muß die Identifikationsreihenfolge berücksichtigt werden. Das heißt, das zuerst der Statorwiderstand und dann der Rotorwiderstand identifiziert werden. Ein fehlerhafter Statorwiderstand führt bei der Rotorwiderstandsermittlung zu falschen Ergebnissen. Im Gegensatz dazu hat der Rotorwiderstand bei der analytischen Bestimmung des Statorwiderstandes keinen Einfluß. Bei Nichtbeachtung dieser Identifikationsreihenfolge werden der Stator- und der Rotorwiderstand nicht genau identifiziert, so daß beim Anfahren die geforderte Zugkraft von der Maschinenregelung nicht genau eingestellt werden kann.

Die Ermittlung einer Regelabweichung kann auf unterschiedliche Art und Weise bestimmt werden.

Bei einer ersten Ausführungsform werden aus den ermittelten Imaginäranteilen der transformierten Statorstrom-Ist- und Modellraumzeiger jeweils ein Betrag bestimmt, die anschließend miteinander verglichen werden. Sind diese ermittelten Beträge der Imaginäranteile der transformierten Statorstrom-Ist- und Modellraumzeiger unterschiedlich, so ist der Rotorwiderstand noch nicht exakt identifiziert.

Bei einer zweiten Ausführungsform wird aus den ermittelten Imaginäranteilen der transformierten Statorstrom-Ist- und Modellraumzeiger eine Modell-Rotorwinkelgeschwindigkeit identifiziert, die mit einem Vorzeichen eines vorbestimmten Drehmoment-Sollwertes multipliziert wird. Ist diese Modell-Rotorwinkelgeschwindigkeit verschieden von Null, so ist der Rotorwiderstand der Drehfeldmaschine noch nicht exakt identifiziert. Die Modell-Rotorwinkelgeschwindigkeit kann bei der Identifizierung der Systemparameter einer geberlosen, feldorientiert betriebenen Drehfeldmaschine deshalb verwendet werden, da diese Identifizierung der Systemparameter im Stillstand der Drehfeldmaschine durchgeführt wird.

Bei einem vorteilhaften Verfahren wird der Statorwiderstand anstatt durch eine analytische Beziehung mit Hilfe eines Reglers identifiziert. Dieses Regelverfahren ähnelt dem Regeiverfahren zur Identifizierung des Rotorwiderstandes, wobei jedoch beim Regelverfahren zur Identifikation des Statorwiderstandes anstelle der Imaginäranteile der transformierten Statorstrom-Ist- und Modellraumzeiger deren Realanteile verwendet werden, die miteinander verglichen werden. Eine ermittelte Regelabweichung ist ein Maß für die Verstimmung des Modell-Statorwiderstandes zum Statorwiderstand der Drehfeldmaschine, die mittels eines Reglers zu Null geregelt wird.

Da dieses Identifikationsverfahren beim Stillstand der Drehfeldmaschine durchgeführt wird und dieses Verfahren auch nur wenige Millisekunden beansprucht, kann man mit diesem Verfahren in der Traktion vor jedem Losfahren den Stator- und den Rotorwiderstand genau identifizieren, wodurch die geforderte Zugkraft von der Maschinenregelung genau eingestellt werden kann. Gerade in der Traktion, insbesondere im Nahverkehr, ändert sich häufig die Belastung der Drehfeldmaschine und es werden ungeachtet von Temperaturbedingungen gleichmäßige Beschleunigungs- und Verzögerungswerte gefordert. Mittels des erfindungsgemäßen Verfahrens kann selbst vor jedem Losfahren der Stator- und Rotorwiderstand identifiziert und somit die geforderte Zugkraft von der Maschinenregelung genau eingestellt werden.

Zur weiteren Erläuterung der Erfindung wird auf die Zeichnung Bezug genommen, in der mehrere Ausführungsbeispiele einer Vorrichtung zur Durchführung des erfindungsgemäßen Verfahren zur Identifikation von Systemparametern Statorwiderstand und Rotorwiderstand einer geberlosen, feldorientiert betriebenen Drehfeldmaschine schematisch veranschaulicht ist.
- FIG 1: zeigt ein Blockschaltbild einer ersten Ausführungsform der Vorrichtung zur Durchführung des erfindungsgemäßen Verfahrens, in der
- FIG 2: ist ein Blockschaltbild einer vorteilhaften ersten Ausführungsform dieser Vorrichtung dargestellt, wobei in der
- FIG 3: ein Blockschaltbild einer zweiten Ausführungsform der Vorrichtung zur Durchführung des erfindungsgemäßen Verfahren dargestellt ist, die
- FIG 4 und FIG 5: zeigen jeweils in einem Diagramm die Statorwiderstandsadaption und die Rotorwiderstandsadaption im Stillstand bei festgebremster Drehfeldmaschine über der Zeit t und die
- FIG 6: zeigt in einem Blockschaltbild eine dritte Ausführungsform der Vorrichtung nach FIG 1.

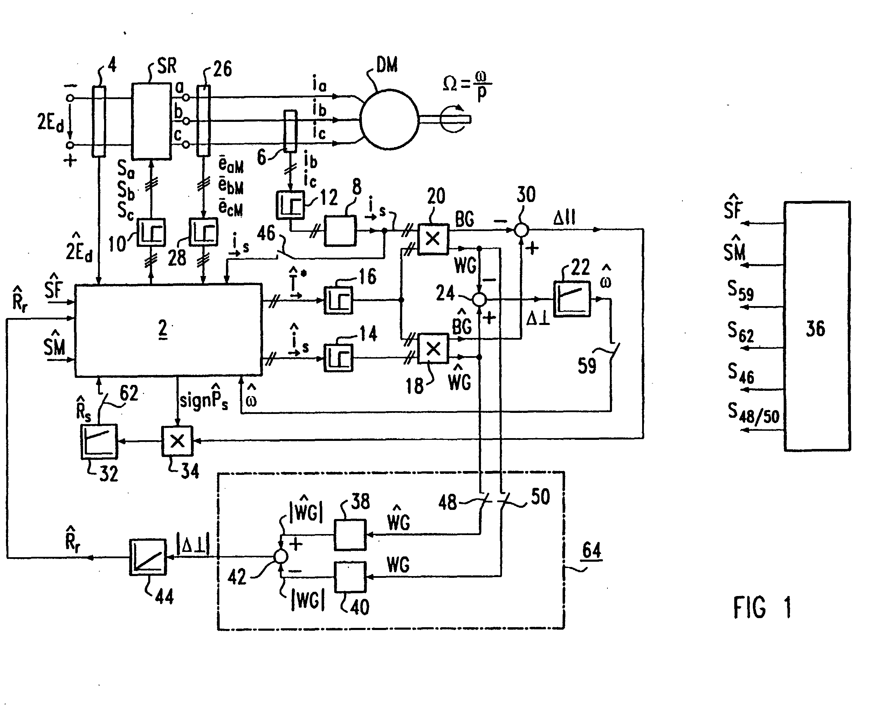

In dem Blockschaltbild gemäß FIG 1 wird ein Pulsstromrichter mit SR und eine Drehfeldmaschine DM bezeichnet. Am Eingang dieses Pulsstromrichters SR steht eine Gleichspannung 2E_{d} an, die mittels einem Meßglied 4 ermittelt wird. Die geberlose Drehfeldmaschine DM ist mit den Anschlüssen a, b, c des Pulsstromrichters SR verbunden. Zur Steuerung und Regelung der geberlosen, feldorientiert betriebenen Drehfeldmaschine DM ist eine Signalverarbeitung 2 vorgesehen, die unter anderem einen Modulator, eine Regelung und ein vollständiges Maschinenmodell enthält.

Diese Signalverarbeitung 2 ist ausgangsseitig über ein Totzeitglied 16 jeweils mit einem Eingang eines ersten und zweiten komplexen Multipliziergliedes 18 und 20 verknüpft. Der zweite Eingang des ersten Multipliziergliedes 18 ist mittels des Totzeitgliedes 14 mit einem Ausgang der Signalverarbeitung 2 verbunden, wogegen ein zweiter Eingang des zweiten Multipliziergliedes 20 mit dem Ausgang eines Koordinatenwandlers8verknüpft ist.Eingangsseitig ist dieser Koordinatenwandler 8 mit einem Meßglied 6 verbunden, mit dem zwei Strangströme i_{b} und i_{c} der Drehfeldmaschine DM gemessen werden können. Die Laufzeit der Signale in der Meßkette wird mittels eines Totzeitgliedes 12 beschrieben. Mittels dieser komplexen Multiplizierglieder 18 und 20 werden Imaginär- und Realanteile eines transformierten Statorstrom-Ist- und Modellraumzeigers ermittelt, die im folgenden auch als Momenten-Wirk- und Blindgrößen WG, BG und 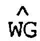 , 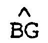 der Drehfeldmaschine DM und des Maschinenmodells der Signalverarbeitung 2 bezeichnet werden. Mittels des komplexen Multipliziergliedes 20 werden die Momenten-Blindgröße BG und die Momenten-Wirkgröße WG der wahren Drehfeldmaschine DM berechnet. Mittels des komplexen Multiplizierers 18 werden die Modellmomenten-Blindgröße 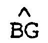 und die Modellmomenten-Wirkgröße 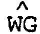 berechnet. Diese Realanteile BG und 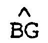 des transformierten Statorstrom-Ist- und Modellraumzeigers 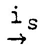 und 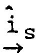 werden einem Vergleicher 30 und deren Imaginäranteile WG und 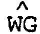 einem Vergleicher 24 derart zugeführt, daß jeweils die Abweichung der wahren Größe von der Modellgröße ermittelt wird. Die Regelabweichung Δ⊥ der Imaginäranteile WG und 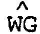 wird über einen Ausgleichsregler 22 mit nachgeschaltetem Schalter 59 der Signalverarbeitung 2 zugeführt, wobei die Regelabweichung Δ∥ der Realanteile BG und 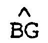 über einen Multiplizierer 34 mit nachgeschaltetem Ausgleichsregler 32 und einem Schalter 62 ebenfalls der Signalverarbeitung 2 zugeführt wird.

Mittels dieser beschriebenen Vorrichtung, die in der älteren nationalen Patentanmeldung mit dem amtlichen Aktenzeichen 195 31 771.8 ausführlich beschrieben ist, wird bei geschlossenen Schaltern 59 und 62 die Rotorgeschwindigkeit ω der geberlosen Drehfeldmaschine DM mit Hilfe einer Modell-Rotorwinkelgeschwindigkeit ω̂ ermittelt, wobei die Regelabweichung Δ⊥ ein Maß für den Fehler der Modell-Rotorwinkelgeschwindigkeit ω̂ ist. Da der Modell-Statorwiderstand R̂ₛ sich stark mit der Wicklungstemperatur ändert, so daß, wenn der Modellwert R̂ₛ des Statorwiderstandes Rₛ nicht nachgeführt wird, die Regelabweichung Δ⊥ am Eingang des Ausgleichsreglers 22 nicht gleich Null wird, selbst wenn die Modell-Rotorwinkelgeschwindigkeit ω̂ und die Rotorwinkelgeschwindigkeit ω übereinstimmen. Der Modell-Statorwiderstand R̂ₛ wird solange verstellt, bis die ermittelte Regelabweichung Δ∥ den Wert Null annimmt.

Mittels dieser Vorrichtung ist jedoch nicht möglich beide Systemparameter Statorwiderstand R̂ₛ und Rotorwiderstand R̂ᵣ, insbesondere den Rotorwiderstand R̂ᵣ im Anfahrbereich, zu bestimmen. Gerade wenn die Belastung der Drehfeldmaschine DM sich häufig ändert und ungeachtet von den Temperaturbedingungen gleichmäßig Beschleunigungs- und Verzögerungswerte erforderlich sind, beispielsweise in der Traktionstechnik im unteren und mittleren Leistungsbereich (Nahverkehr), müssen die geforderten Zugkräfte von der Maschinenregelung genau eingestellt werden. Das heißt, vor jedem Losfahren werden die exakten Werte der Systemparameter Statorwiderstand R̂ₛ und Rotorwiderstand R̂ᵣ benötigt.

Dies gelingt mit dem erfindungsgemäßen Verfahren, wobei die Vorrichtung zur Durchführung dieses Verfahren in die Vorrichtung zur Bestimmung der Drehzahl einer geberlosen, feldorientiert betriebenen Drehfeldmaschine DM integriert ist. Die Steuerung des Ablaufes dieses erfindungsgemäßen Verfahrens wird von einer Systemsteuerung 36, auch als Zugsteuerung bezeichnet, durchgeführt.

Diese Vorrichtung zur Durchführung des erfindungsgemäßen Verfahrens zur Identifikation der Systemparameter Statorwiderstand R̂ₛ und Rotorwiderstand R̂ᵣ weist eine Einrichtung 64 zur Ermittlung einer Regelabweichung |Δ⊥|, einen Regler 44 und einen Schalter 46 auf. Diese Einrichtung 64 weist zwei Betragsbildner 38 und 40, einen Vergleicher 42 und zwei Schalter 48 und 50 auf. Der Schalter 46 verbindet den Ausgang des Koordinatenwandlers 8 mit der Signalverarbeitung 2, wobei dieser Schalter 46 mittels eines Steuersignals S₄₆ von der Systemsteuerung 36 betätigt wird. Der Eingang des Betragsbildners 38 ist eingangsseitig mittels des Schalters 48 mit dem Ausgang des ersten komplexen Multipliziergliedes 18 verbunden, an dem der Imaginäranteil 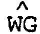 des transformierten Statorstrom-Modellraumzeigers 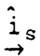 ansteht. Der Eingang des Betragsbildners 40 ist mittels des Schalters 50 mit einem Ausgang des komplexen Multipliziergliedes 20 verbunden, an dem der Imaginäranteil WG des transformierten Statorstrom-Istraumzeigers 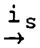 ansteht. Ausgangsseitig ist der Betragsbildner 38 mit einem nichtinvertierenden Eingang des Vergleichers 42 verknüpft, wogegen der Ausgang des Betragsbildner 40 mit seinem invertierenden Eingang verbunden ist. Der Ausgang dieses Vergleichers 42 ist mit dem Regler 44 verbunden, dessen Ausgang mit einem Parametereingang der Signalverarbeitung 2 verknüpft ist. Als Regler 44 ist hier ein I-Regler vorgesehen. Jedoch kann auch ein PI-Regler verwendet werden.

Anhand dieses Blockschaltbildes soll nun das erfindungsgemäße Verfahren näher erläutert werden:

Zunächst muß die Drehfeldmaschine DM aufmagnetisiert sein.

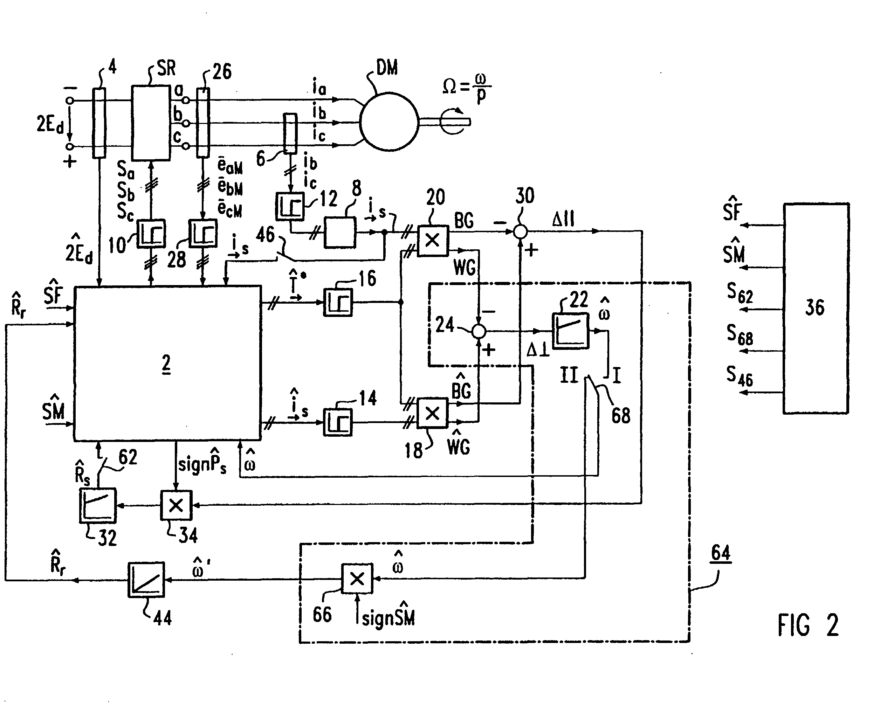

Dazu gibt die Systemsteuerung 36 einen Sollwert 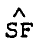 für die Stärke des magnetischen Drehfeldes ab. Der Sättigungszustand der Maschine DM kann beschrieben werden durch den Betrag der Grundschwingungsraumzeiger von Statorfluß und Statorstrom 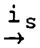 .Dieser Statorstrom-Istraumzeiger 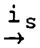 steht am Ausgang des Koordinatenwandlers 8 an und gelangt über den geschlossenen Schalter 46 zur Signalverarbeitung 2. Ist die Drehfeldmaschine DM aufmagnetisiert, so wird diese Maschine DM im Stillstand mit einer Gleichspannung 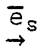 gespeist und der Statorstrom-Istraumzeiger 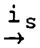 ermittelt. Mittels einer analytischen Beziehung wird aus den Gleichspannungswert 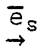 (ν) und dem gemessenen Statorstrommittelwert 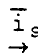 (ν) über ein Modulationsspiel der Statorwiderstand R̂ₛ exakt ermittelt. Anschließend werden die Schalter 48, 50 von der Systemsteuerung 36 mittels des Steuersignals S_{48/50} geschlossen und ein vorbestimmter Drehmoment-Sollwert 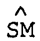 wird von der Systemsteuerung 36 an die Signalverarbeitung 2 abgegeben. Der Schalter 46 ist zu diesem Zeitraum wieder geöffnet. Außerdem sind die Schalter 59 und 62 während des Verfahrens zur Identifikation von Systemparametern geöffnet. Dazu werden von der Systemsteuerung 36 Steuersignale S₅₉ und S₆₂ generiert. Der Drehmoment-Sollwert 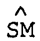 wird so gewählt, daß gewährleistet werden kann, daß die Drehzahl Null ist. Beispielsweise ist der Sollwert 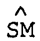 gleich 20 % des Kippmoments Mₖᵢₚₚ der Drehfeldmaschine DM. Mittels der Signalverarbeitung 2 und der beiden komplexen Multiplizierglieder 18 und 20 erhält man eine Momenten-Wirkgröße WG und eine Modellmomenten-Wirkgröße 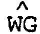 , von denen mittels der Betragsbildner 38 und 40 jeweils deren Beträge Modellmomenten-Wirkgröße | 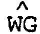 | und |WG| berechnet werden. Diese Betrags-Imaginäranteile | 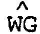 | und |WG| werden mittels des Vergleichers 42 miteinander verglichen. Eine mittels der Einrichtung 64 ermittelte Regelabweichung |Δ⊥| wird dem Regler 44 zugeführt, dessen Ausgangsgröße Rotorwiderstand R̂ᵣ einem Eingang der Signalverarbeitung 2 zugeführt wird. Dieser Rotorwiderstand R̂ᵣ wird solange verstellt, bis die Regelabweichung |Δ⊥| zu Null geworden ist. Ist diese Regelabweichung |Δ⊥| Null, so sind die Systemparameter Statorwiderstand R̂ₛ und Rotorwiderstand R̂ᵣ identifiziert und sind in der Signalverarbeitung 2 übernommen worden. Die Schalter 48 und 50 werden nun wieder von der Systemsteuerung 36 geöffnet und die Schalter 59 und 62 wieder geschlossen, so daß die Drehfeldmaschine DM mit einer geforderten Zugkraft anfahren kann. Die FIG 2 zeigt ein Blockschaltbild einer vorteilhaften Ausführungsform der ersten Ausführungsform nach FIG 1. Der Unterschied dieser vorteilhaften Ausführungsform zur Ausführungsform gemäß FIG 1 besteht in der Ausgestaltung der Einrichtung 64 zur Ermittlung einer Regelabweichung ω̂'. Diese Einrichtung 64 weist einen Vergleicher, einen Regler und einen Multiplizierer 66 auf. Da die Vorrichtung der älteren nationalen Patentanmeldung mit dem amtlichen Aktenzeichen 195 31 771.8 bereits einen Vergleicher 24 und einen Regler 22, der als Ausgleichsregler bezeichnet wird, aufweist, werden diese beiden Elemente auch bei Ermittlung der Regelabweichung ω̂' verwendet. Da diese beiden Elemente 24 und 22 bei unterschiedlichen nicht zeitsynchron ablaufenden Verfahren verwendet werden, ist dem Regler 22 ein Umschalter 68 nachgeschaltet. Mittels diesem Umschalter 68, der mittels eines Steuersignals S₆₈ der Systemsteuerung 36 betätigt wird, kann der Ausgang des Ausgleichsreglers 22 einerseits mit einem Parametereingang der Signalverarbeitung 2 (Position I) und andererseits mit dem Multiplizierer 66 der Einrichtung 64 (Position II) verbunden werden.

Am Ausgang des Ausgleichsreglers 22 steht der Wert einer Modell-Rotorwinkelgeschwindigkeit ω̂ an, der mittels des Multiplizierers 66 mit einem Vorzeichensignal sign 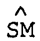 eines vorbestimmten Drehmoment-Sollwertes gewichtet wird. Am Ausgang dieses Multiplizierers 66 steht eine Regelabweichung ω̂' an, die dem Regler 44 zugeführt wird, dessen Ausgangsgröße Rotorwiderstand R̂ᵣ der Signalverarbeitung 2 zugeführt wird.

Dieser Rotorwiderstand R̂ᵣ wird solange verstellt, bis die Regelabweichung Δ⊥ und die ermittelte Modell-Rotorwinkelgeschwindigkeit ω̂ zu Null geworden sind. Ist diese Bedingung erfüllt, so sind die Systemparameter Statorwiderstand R̂ₛ und Rotorwiderstand R̂ᵣ identifiziert und sind in der Signalverarbeitung 2 übernommen worden. Anschließend werden der Schalter 46 geöffnet und der Umschalter 68 in die Position I umgeschaltet, so daß die Drehfeldmaschine DM mit einer geforderten Zugkraft anfahren kann.

Bei der Verwendung dieses Identifikationsverfahren in der Traktion, insbesondere bei Nahverkehrszügen, wird der vorbestimmte Drehmoment-Sollwert 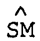 unmittelbar vor dem erneuten Losfahren nach dem Schließen der Türen aufgeschaltet. Sind die Türen noch offen, so wird kein Drehmoment-Sollwert 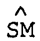 aufgeschaltet. Damit das Fahrzeug sich durch die Aufschaltung des Drehmoment-Sollwertes 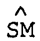 nicht in Bewegung setzen kann, sind die mechanischen Bremsen dieser Traktion angezogen.

Um die mechanischen Bremsen zu entlasten, können beispielsweise jeweils die einzelnen Antriebsgruppen nacheinander mit dem notwendigen Drehmoment 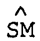 beaufschlagt werden. Eine andere Möglichkeit zur Reduzierung der Anforderung an die Bremsen besteht darin, daß als Drehmoment-Sollwert 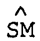 eine gleichanteilsfreie Wechselgröße vorgesehen wird. Dabei muß die Frequenz des Drehmoment-Sollwertes 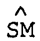 so groß gewählt werden, daß nach außen aufgrund der Trägheit des Systems das Drehmoment nicht wirksam wird. Beim Einsatz von mehreren Pulsstromrichtern, die unterschiedliche Motoren speisen, kann die Ansteuerung so erfolgen, daß die Motoren ein entgegengesetzt gleich großes Drehmoment abgeben. Durch dieses Verspannen der Motoren gegeneinander ergänzt sich dann das resultierende Drehmoment zu Null. Durch diese Methoden können jeweils die mechanischen Bremsen stark entlastet werden.

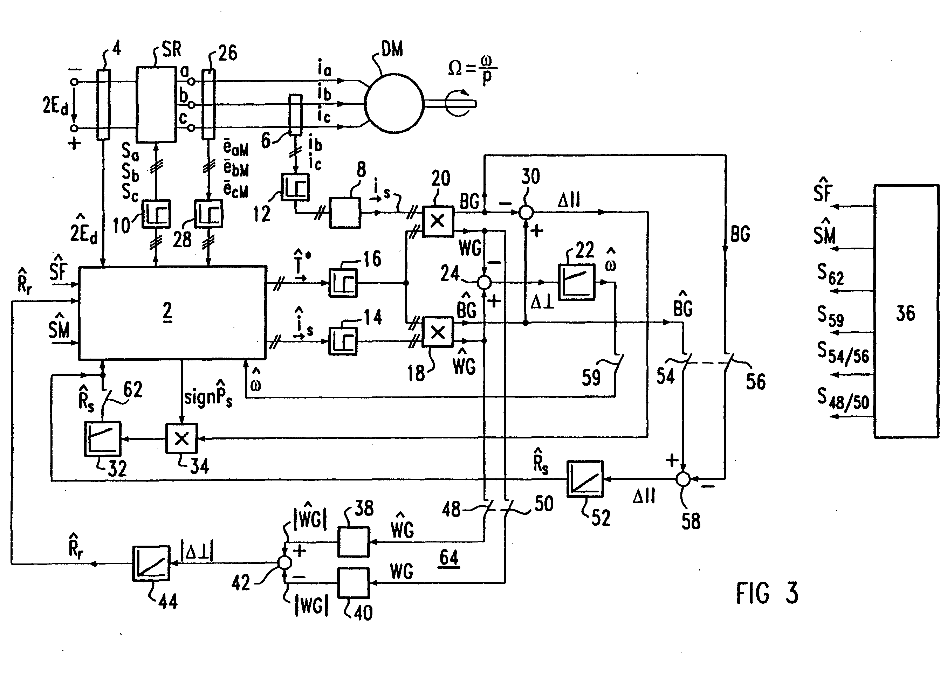

Die FIG 3 zeigt ein Blockschaltbild einer zweiten Ausführungsform der Vorrichtung nach FIG 1. Gegenüber der Ausführungsform gemäß FIG 1 weist diese zweite Ausführungsform einen weiteren Regler 52, zwei weitere Schalter 54 und 56 und einen weiteren Vergleicher 58 auf. Die Ausgänge der komplexen Multiplizierglieder 18 und 20, an denen die Realanteile BG und 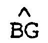 des transformierten Statorstrom-Ist- und Modellraumzeigers 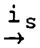 und 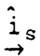 anstehen, sind mittels der Schalter 56 und 54 jeweils mit einem Eingang des weiteren Vergleichers 58 verbunden. Der Ausgang dieses weiteren Vergleichers 58 ist mittels des weiteren Reglers 52 mit einem Parametereingang der Signalverarbeitung 2 verknüpft. Der Vergleicher 58 vergleicht diese Realanteile BG und 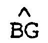 miteinander. Eine ermittelte Regelabweichung Δ∥ wird dem Regler 52 zugeführt, an dessen Ausgang ein Wert des Systemparameter Statorwiderstand R̂ₛ ansteht. Dieser Statorwiderstandswert R̂ₛ wird solange in der Signalverarbeitung 2 verstellt, bis die Regelabweichung Δ∥ Null ist. Sobald die Regelabweichung Δ∥ Null ist, ist der Statorwiderstand R̂ₛ identifiziert und es kann, wie bereits beschrieben, der Rotorwiderstand R̂ᵣ identifiziert werden. Bei dieser zweiten Ausführungsform wird der Statorwiderstand R̂ₛ nicht mittels einer analytischen Beziehung berechnet, sondern mit Hilfe einer Regelung ermittelt.

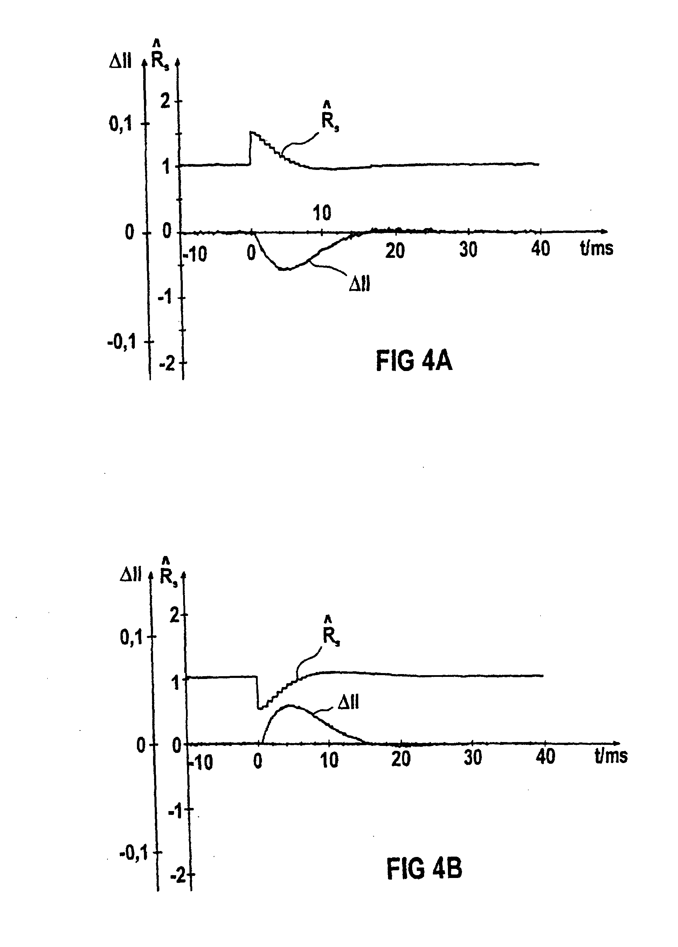

Die FIG 4 zeigt graphisch die Adaption des Statorwiderstandes, nachdem der Statorwiderstand R̂ₛ um 50 % verstellt ist.

Diese Verstellung des Statorwiderstand R̂ₛ wird innerhalb von 15 ms ausgeregelt.

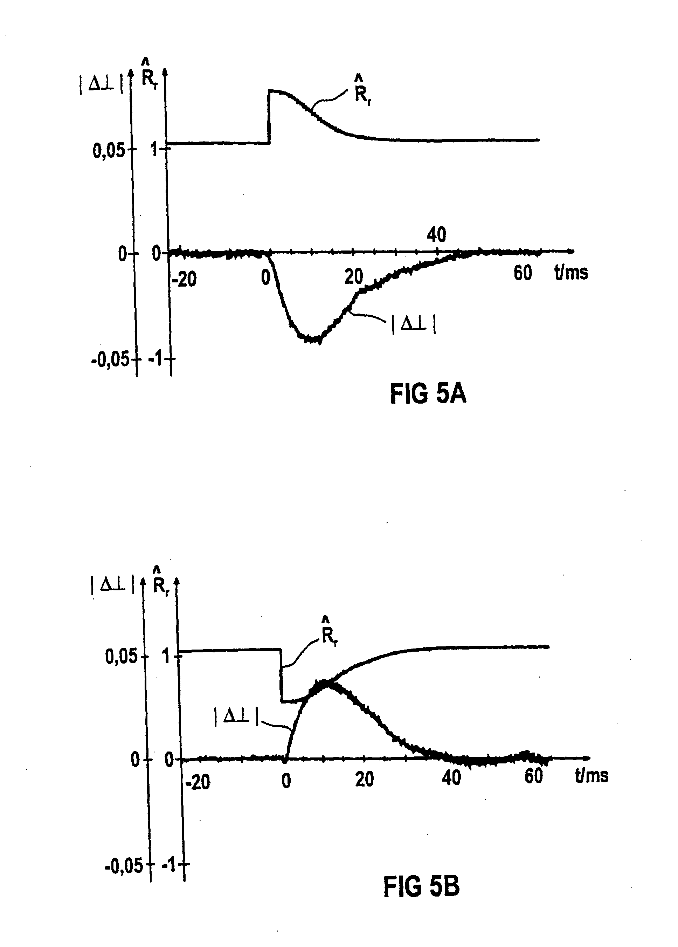

In der FIG 5 ist die Adaption des Rotorwiderstands R̂ᵣ graphisch dargestellt. Der Rotorwiderstand R̂ᵣ wird bei einem 50 % falschen Startwert innerhalb von beispielsweise drei Rotorstreuzeitkonstanten ausgeregelt.

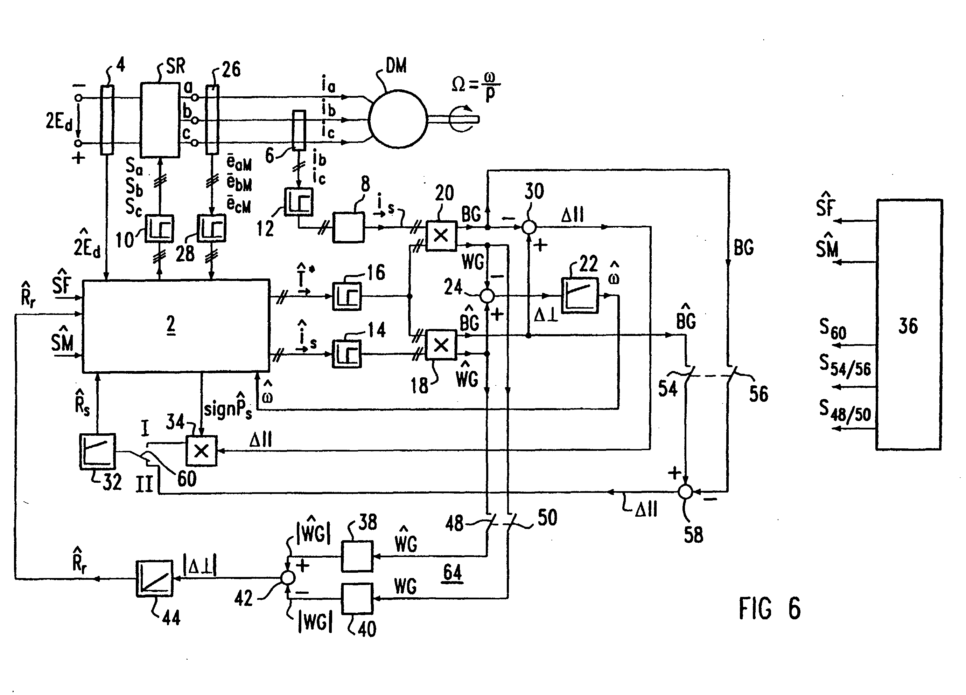

In der FIG 6 ist eine dritte Ausführungsform der Vorrichtung nach FIG 1 dargestellt. Diese Ausführungsform unterscheidet sich von der Ausführungsform gemäß FIG 3 dadurch, daß anstelle des weiteren Reglers 52 ein Umschalter 60 vorgesehen ist, der einerseits den Ausgleichsregler 32 mit dem Multiplizierer 34 (Position I) und andererseits den Ausgleichsregler 32 mit dem weiteren Vergleicher 58 (Position II) verbindet. Auch dieser Umschalter 60 wird mittels eines Steuersignals S₆₀ von der Systemsteuerung 36 betätigt. Durch die Verwendung des Umschalters 60 kann der bereits vorhandene Ausgleichsregler 32 auch bei der Identifikation des Statorwiderstand R̂ₛ im Stillstand der Drehfeldmaschine DM benutzt werden. Ansonsten läuft die Statorwiderstand-Identifikation wie bei der Ausführungsform gemäß FIG 3 ab.

Mit diesem erfindungsgemäßen Verfahren besteht die Möglichkeit, selbst bei Betrieb ohne Drehzahlgeber die Motorparameter Statorwiderstand R̂ₛ und Rotorwiderstand R̂ᵣ bei jedem Halt unmittelbar vor dem Losfahren zu identifizieren. Dadurch kann beim Anfahren gewährleistet werden, daß das geforderte Drehmoment recht genau von der Maschinenregelung eingestellt und somit die Drehzahl der geberlosen Drehfeldmaschine DM ausreichend genau berechnet werden kann.

## Patentansprüche

1. Verfahren zur Identifikation der Systemparameter Statorwiderstand (R̂ₛ) und Rotorwiderstand (R̂ᵣ) einer geberlosen, feldorientiert betriebenen Drehfeldmaschine (DM), insbesondere einer Traktions-Drehfeldmaschine, wobei beim Stillstand der aufmagnetisierten Drehfeldmaschine (DM) folgende Verfahrensschritte durchgeführt werden:
a) Speisung der Drehfeldmaschine (DM) mit einer eingeprägten Gleichspannung ( 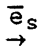 )
b) Ermittlung eines Gleichstrom-Istwertes (iₛ) mit anschließender Berechnung des Systemparameters Statorwiderstand (R̂ₛ) in Abhängigkeit der eingeprägten Gleichspannung ( 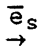 ) und dieses Gleichstrom-Istwertes (iₛ)
c) Aufschaltung eines vorbestimmten Drehmoment-Sollwertes ( 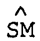 ) auf die Drehfeldmaschine (DM)
d) Transformation eines aus gemessenen Statorströmen ermittelten Statorstrom-Istraumzeigers ( 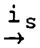 ) und eines berechneten Statorstrom-Modellraumzeigers ( 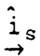 ) in ein feldorientiertes komplexes Bezugssystem mittels eines konjugiert komplexen Bezugsraumzeigers ( 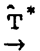 )
e) Aufspaltung dieser transformierten Statorstrom-Ist- und Modellraumzeiger ( 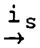 , 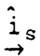 ) jeweils in einen Real- und Imaginäranteil (BG, 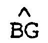 , WG, 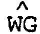 )
f) Bestimmung einer Regelabweichung (|Δ⊥|, ω̂') zur Verstellung des Systemparameters Rotorwiderstand (R̂ᵣ), in Abhängigkeit der Imaginäranteile (WG, 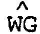 ) dieser transformierten Statorstrom-Ist- und Modellraumzeiger ( 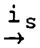 , 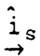 ) und
g) Verwendung dieser ermittelten Regelabweichung (|Δ⊥|, ω̂') derart zur Verstellung des Systemparameters Rotorwiderstand (R̂ᵣ), daß diese ermittelte Regelabweichung (|Δ⊥|, ω̂') zu Null wird.

2. Verfahren nach Anspruch 1, wobei zur Ermittlung einer Regelabweichung (|Δ⊥|) Beträge der Imaginäranteile (WG, 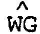 ) der transformierten Statorstrom-Ist- und Modellraumzeiger ( 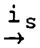 , 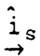 ) bestimmt werden, die anschließend miteinander verglichen werden, wobei die ermittelte Abweichung dieser Beträge (|WG|, | 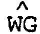 |) die Regelabweichung (|Δ⊥|) ist.

3. Verfahren nach Anspruch 1, wobei zur Ermittlung einer Regelabweichung (ω̂') die Imaginäranteile (WG, | 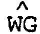 |) der transformierten Statorstrom-Ist- und Modellraumzeiger ( 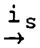 , 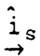 ) miteinander verglichen werden und aus der daraus ermittelten Regelabweichung (Δ⊥) eine Modell-Rotorwinkelgeschwindigkeit (ω̂) bestimmt wird, die mit dem Vorzeichen eines vorbestimmten Drehmoment-Sollwertes ( 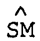 ) multipliziert wird.

4. Verfahren nach Anspruch 1 oder 2, wobei der Systemparameter Statorwiderstand (R̂ₛ) anstelle durch eine analytische Beziehung mit folgenden Verfahrensschritten bestimmt wird:
a) Aufschaltung eines vorbestimmten Drehmoment-Sollwertes ( 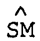 ) auf die Drehfeldmaschine (DM)
b) Transformacion eines aus gemessenen Statorströmen (i_{b}, i_{c}) ermittelten Statorstrom-Istraumzeigers ( 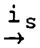 ) und eines ermittelten Statorstrom-Modellraumzeigers ( 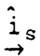 ) in ein feldorientiertes komplexes Bezugssystem mittels eines konjugiert komplexen Bezugsraumzeigers ( 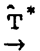 )
c) Aufspaltung dieser transformierten Statorstrom-Ist- und Modellraumzeiger ( 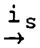 , 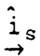 ) jeweils in einen Real- und Imaginäranteil (BG, 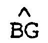 , WG, 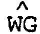 )
d) Bestimmung einer Regelabweichung (Δ∥) zur Verstellung des Systemparameters Statorwiderstand (R̂ₛ) durch einen Vergleich der ermittelten Realanteile (BG, 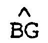 ) dieser transformierten Statorstrom-Ist- und Modellraumzeiger ( 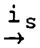 , 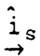 ) und
e) Verwendung dieser Regelabweichung (Δ∥) derart zur Verstellung des Systemparameters Statorwiderstand (R̂ₛ), daß die ermittelte Regelabweichung (Δ∥) zu Null wird.

5. Verfahren nach einem der Ansprüche 1 bis 4 mit einer Traktion, die mehrere geberlose, feldorientiert betriebene Drehfeldmaschinen (DM) aufweist, wobei der vorbestimmte Drehmoment-Sollwert ( 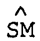 ) nacheinander auf die mehreren Drehfeldmaschinen (DM) aufgeschaltet wird.

6. Verfahren nach Anspruch 5, wobei auf jeweils zwei Drehfeldmaschinen (DM) ein vorbestimmter Drehmoment-Sollwert ( 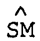 ) entgegengesetzt aufgeschaltet wird.

7. Verfahren nach einem der vorgenannten Ansprüche 1 bis 6, wobei als Drehmoment-Sollwert ( 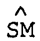 ) eine gleichanteilsfreie Wechselgröße verwendet wird.

8. Vorrichtung zur Durchführung des Verfahrens nach Anspruch 1 mit einer Systemsteuerung (36), einer Signalverarbeitung (2), die unter anderem ein vollständiges Maschinenmodell und einen Modulator enthalt, einem Meßglied (6) mit nachgeschaltetem Koordinatenwandler (8), zwei komplexen Multipliziergliedern (18, 20) und zwei Vergleichern (24, 30), wobei ein Ausgang der Signalverarbeitung (2), an dem ein konjugiert komplexer Bezugsraumzeiger ( 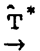 ) ansteht, jeweils mit einem Eingang der komplexen Multiplizierglieder (18, 20) verbunden ist, wobei der Ausgang des Koordinatenwandlers (8) mit einem zweiten Eingang des zweiten Multipliziergliedes (20) verknüpft ist, wobei ein Ausgang der Signalverarbeitung (2), an dem ein ermittelter Statorstrom-Modellraumzeiger ( 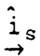 ) ansteht, mit einem zweiten Eingang des ersten Multipliziergliedes (18) verbunden ist und wobei die Imaginär-Ausgänge der beiden Multiplizierglieder (18, 20) mit den Eingängen des ersten Vergleichers (24) und deren Real-Ausgänge mit den Eingängen des zweiten Vergleichers (30) verknüpft sind, **dadurch gekennzeichnet, daß** der Ausgang des Koordinatenwandlers (8) außerdem mittels eines Schalters (46) mit der Signalverarbeitung (2) verknüpft ist, daß die Imaginär-Ausgänge der beiden komplexen Multiplizierglieder (18, 20) mittels einer Einrichtung (64) zur Ermittlung einer Regelabweichung (|Δ⊥|, ω̂') mit einem Regler (44) verknüpft sind, der ausgangsseitig mit einem Parametereingang für den Systemparameter Rotorwiderstand (R̂ᵣ) der Signalverarbeitung (2) verbunden ist und daß diese Einrichtung (64) und die Signalverarbeitung (2) mit der Systemsteuerung (36) verknüpft sind.

9. Vorrichtung nach Anspruch 8, **dadurch gekennzeichnet, daß** die Einrichtung (64) zur Ermittlung der Regelabweichung (|Δ⊥|) zwei Schalter (48, 50), zwei Betragsbildner (38, 40) und einen Vergleicher (42) aufweist, wobei diese Betragsbildner (38, 40) eingangsseitig jeweils mit einem Schalter (48, 50) und ausgangsseitig mit einem Eingang des Vergleichers (42) verknüpft sind, an dessen Ausgang die ermittelte Regelabweichung (|Δ⊥|) ansteht und wobei die Schalter (48, 50) eingangsseitig mit den Imaginär-Ausgängen der komplexen Multiplizierglieder (18, 20) verbunden sind.

10. Vorrichtung nach Anspruch 8, **dadurch gekennzeichnet, daß** die Einrichtung (64) zur Ermittlung der Regelabweichung (ω̂') einen Vergleicher (24), einen Ausgleichsregler (22) und einen Multiplizierer (66) aufweist, wobei der Ausgleichsregler (22) eingangsseitig mit dem Ausgang des ersten Vergleichers (24) und ausgangsseitig mit dem Multiplizierer (66), an dessen zweiten Eingang ein Vorzeichen-Signal (sign 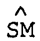 ) eines vorbestimmten Drehmoment-Sollwertes ( 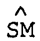 ) ansteht, verknüpft ist und wobei der Vergleicher (24) eingangsseitig mit den Ausgängen der komplexen Multiplizierer (18, 20) verbunden ist.

11. Vorrichtung nach einem der Ansprüche 8 oder 9, **dadurch gekennzeichnet, daß** die Real-Ausgänge der beiden komplexen Multiplizierglieder (18, 20) jeweils über einen Schalter (54, 56) mit einem Vergleicher (58) verknüpft sind, daß dieser Vergleicher (58) ausgangsseitig mittels eines Reglers (52) mit einem Parametereingang für den Systemparameter Statorwiderstand (R̂ₛ) der Signalverarbeitung (2) verbunden ist und daß die Schalter (54, 56) mit der Systemsteuerung (36) verknüpft sind.

12. Vorrichtung nach Anspruch 11, **dadurch gekennzeichnet, daß** der Vergleicher (58) ausgangsseitig mittels eines Umschalters (60) mit einem Ausgleichsregler (32) verknüpfbar ist, der ausgangsseitig mit dem Parametereingang für den Systemparameter Statorwiderstand (R̂ₛ) verbunden ist.

13. Vorrichtung nach einem der Ansprüche 8, 9, 10, 11 oder 12, **dadurch gekennzeichnet, daß** als Regler (44, 52) ein I-Regler vorgesehen ist.

14. Vorrichtung nach einem der Ansprüche 8, 9, 10, 11 oder 12, **dadurch gekennzeichnet, daß** als Regler (44, 52) ein PI-Regler vorgesehen ist.

15. Vorrichtung nach einem der Ansprüche 8 bis 14, **dadurch gekennzeichnet, daß** diese Vorrichtung und die Signalverarbeitung (2) eine Baueinheit bilden.

## Claims

1. Method of identifying the system parameters stator resistance (*R̂*_{*s*}) and rotor resistance (*R̂*_{*r*}) of a polyphase machine (DM) which does not have sensors as it is operated in the field-oriented manner, in particular a polyphase traction machine, with the following steps being performed at standstill of the magnetised polyphase machine (DM):
a) the polyphase machine (DM) is supplied with an applied DC voltage ( 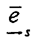 );
b) a direct current actual value (iₛ) is determined, the system parameter stator resistance (*R̂*_{*s*}) being subsequently calculated as a function of the DC voltage ( 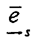 ) applied and of this direct current actual value (iₛ);
c) a predefined torque setpoint value ( 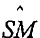 ) is applied to the polyphase machine (DM);
d) a stator current actual space vector ( 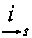 ) calculated from measured stator currents and a computed stator current model space vector ( 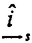 ) are transformed into a field-oriented complex reference system using a conjugated complex reference space vector ( 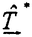 );
e) this transformed stator current actual space vector and stator current model space vector ( 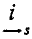 , 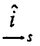 ) are each split into a real and an imaginary component (BG, 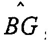 , WG, 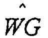 );
f) a system deviation (|Δ_{⊥}|, ω̂') is determined to adjust the system parameter rotor resistance (*R̂*_{*r*}) as a function of the imaginary components (WG, 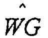 ) of this transformed stator current actual space vector and stator current model space vector ( 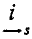 , 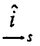 ); and
g) this computed system deviation (|Δ_{⊥}|, ω̂') is used to adjust the system parameter rotor resistance (*R̂*_{*r*}) so that this computed system deviation (|Δ_{⊥}|, ω̂') becomes zero.

2. Method according to Claim 1, wherein, in order to determine a system deviation (|Δ_{⊥}|), absolute values of the imaginary components (WG, 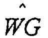 ) of the transformed stator current actual space vector and stator current model space vector ( 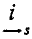 , 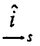 ) are determined, which are subsequently compared to one another, with the computed difference of these absolute values (|WG|, | 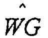 |) being the system deviation (|Δ_{⊥} |).

3. Method according to Claim 1, wherein, in order to determine a system deviation (ω̂'), the imaginary components (WG,| 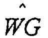 |) of the transformed stator current actual space vector and stator current model space vector ( 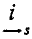 , 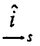 ) are compared and a model rotor angular velocity (ω̂) is determined from the computed system deviation (Δ_{⊥} ) and is multiplied by the sign of a predefined torque setpoint value ( 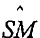 ).

4. Method according to Claim 1 or 2, wherein the system parameter stator resistance (*R̂*_{*s*}) is determined not via an analytical equation, but using the following steps:
a) a predefined torque setpoint value ( 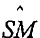 ) is applied to the polyphase machine (DM);
b) a stator current actual space vector ( 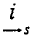 ) calculated from measured stator currents (i_{b}, i_{c}) and a calculated stator current model space vector ( 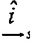 ) are transformed into a field-oriented complex reference system using a conjugated complex reference space vector ( 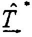 );
c) this transformed stator current actual space vector and stator current model space vector ( 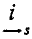 , 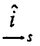 ) are each split into a real and an imaginary component (BG, 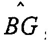 , WG, 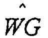 );
d) a system deviation (Δ_{∥}) is determined to adjust the system parameter stator resistance (*R̂*_{*s*}) by comparing the calculated real components (BG, 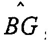 ) of this transformed stator current actual space vector and stator current model space vector ( 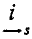 , 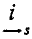 ); and
e) this system deviation (Δ_{∥}) is used to adjust the system parameter stator resistance (*R̂*_{*s*}) so that the computed system deviation (Δ_{∥}) becomes zero.

5. Method according to one of Claims 1 to 4 having a traction that has a plurality of polyphase machines (DM) without sensors operated in the field-oriented manner, the predefined torque setpoint value ( 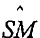 ) being applied consecutively to the plurality of polyphase machines (DM).

6. Method according to Claim 5, with opposite values of a predefined torque setpoint value ( 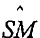 ) being applied to two polyphase machines (DM).

7. Method according to one of the foregoing Claims I to 6, with a direct component-free alternate quantity being used as the torque setpoint value ( 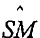 ).

8. Device for performing the method according to Claim 1 having a system controller (36), a signal processor (2), which includes, among other things, a full machine model and a modulator, a measuring element (6) with a downstream coordinate converter (8), two complex multipliers (18, 20) and two comparators (24, 30), one output of the signal processor (2), where a conjugated complex reference space vector ( 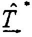 ) appears, being connected to an input of each of the complex multipliers (18, 20), the output of the coordinate converter (8) being connected to a second input of the second multiplier (20), one output of the signal processor (2), where a calculated stator current model space vector ( 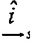 ) appears, being linked to a second input of the first multiplier (18) and the imaginary outputs of both multipliers (18, 20) being linked to the inputs of the first comparator (24) and their real outputs being linked to the inputs of the second comparator (30), **characterised in that** the output of the coordinate converter (8) is also linked to the signal processor (2) via a switch (46); the imaginary outputs of both complex multipliers (18, 20) are linked to a regulator (44) via a device (64) for determining a system deviation (|Δ_{⊥}|, ω̂'), the output of the regulator being connected to a parameter input of the signal processor (2) for the system parameter rotor resistance (*R̂*_{*r*}); and this device (64) and the signal processor (2) are linked to the system controller (36).

9. Device according to Claim 8, **characterised in that** the device (64) for determining the system deviation (|Δ_{⊥}|) has two switches (48, 50), two absolute value formers (38, 40), and a comparator (42), the inputs of these absolute value formers (38, 40) each being connected to a switch (48, 50), and their outputs being connected to an input of the comparator (42), at whose output the calculated system deviation (|Δ_{⊥}|) appears, and the inputs of the switches (48, 50) being connected to the imaginary outputs of the complex multipliers (18, 20).

10. Device according to Claim 8, **characterised in that** the device (64) for determining the system deviation (ω̂') has a comparator (24), an equalising regulator (22) and a multiplier (66), the input of the equalising regulator (22) being connected to the output of the first comparator (24) and its output being connected to the multiplier (66), at whose second input a sign signal (sign 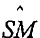 ) of a predefined torque setpoint value ( 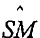 ) is applied, and the input of the comparator (24) being connected to the outputs of the complex multipliers (18, 20).

11. Device according to one of Claims 8 or 9, **characterised in that** the real outputs of the two complex multipliers (18, 20) are each connected to a comparator (58) via a switch (54, 56); the output of this comparator (58) is connected to a parameter input for the system parameter stator resistance (*R̂*_{*s*}) of the signal processor (2) via a regulator (52), and the switches (54, 56) are connected to the system controller (36).

12. Device according to Claim 11, **characterised in that** the output of the comparator (58) is connectable, via a double-throw switch (60), to an equalising regulator (32), whose output is connected to the parameter input for the system parameter stator resistance (*R̂*_{*s*}).

13. Device according to one of Claims 8, 9, 10, 11 or 12, **characterised in that** an I regulator is provided as the regulator (44, 52).

14. Device according to one of Claims 8, 9, 10, 11 or 12, **characterised in that** a PI regulator is provided as the regulator (44, 52).

15. Device according to one of Claims 8 to 14, **characterised in that** this device and the signal processor (2) form a single unit.

## Revendications

1. Procédé pour identifier des paramètres de systèmes, à savoir la résistance de stator (R̂ₛ) et la résistance de rotor (R̂ᵣ), d'une machine polyphasée (DM) sans capteur et à orientation de champ, notamment d'une machine polyphasée de traction, les étapes de procédé suivantes étant réalisées à l'arrêt de la machine polyphasée (DM) magnétisée :
a) alimentation de la machine polyphasée (DM) avec une tension continue appliquée ( 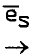 ),
b) détermination d'une valeur réelle de courant continu (iₛ) avec calcul consécutif du paramètre de système résistance de stator (R̂ₛ en fonction de la tension continue appliquée ( 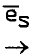 ) et de cette valeur réelle de courant continu (iₛ),
c) application d'une valeur de consigne de couple prédéterminée ( 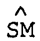 ) à la machine polyphasée (DM),
d) transformation d'un vecteur spatial réel de courant statorique déterminé ( 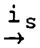 ) et d'un vecteur spatial de modèle de courant statorique calculé ( 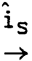 ) dans un système de référence complexe à orientation de champ au moyen d'un vecteur spatial de référence complexe conjugué ( 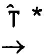 ),
e) division de ces vecteurs réel et de modèle de courant statorique transformés ( 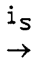 , 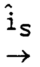 ) à chaque fois en une partie réelle et une partie imaginaire (BG, 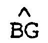 , WG, 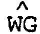 ),
f) détermination d'un écart de régulation (|Δ⊥|, ω̂') pour le réglage du paramètre de système résistance de rotor (R̂ᵣ), en fonction des parties imaginaires (WG, 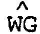 ) de ces vecteurs réel et de modèle de courant statorique transformés ( 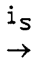 , 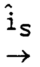 ), et
g) utilisation de cet écart de régulation déterminé (|Δ⊥|, ω̂') pour le réglage du paramètre de système résistance de rotor (R̂ᵣ) de telle sorte que cet écart de régulation déterminé (|Δ⊥|, ω̂') s'annule.

2. Procédé selon la revendication 1, dans lequel, pour déterminer un écart de régulation (|Δ⊥|), on détermine des valeurs absolues de parties imaginaires (WG, 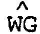 ) des vecteurs réel et de modèle de courant statorique transformés ( 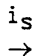 , 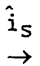 ) qui sont ensuite comparées entre elles, l'écart déterminé de ces valeurs absolues (|WG|, | 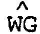 |) étant l'écart de régulation (|Δ⊥|).

3. Procédé selon la revendication 1, dans lequel, pour déterminer un écart de régulation (ω̂'), on compare entre elles les valeurs absolues de parties imaginaires (WG, | 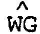 |) des vecteurs réel et de modèle de courant statorique transformés 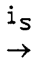 , 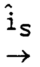 ) et on détermine à partir de l'écart de régulation ainsi obtenu (Δ⊥) une vitesse angulaire de rotor de modèle (ω̂) qui est multipliée par le signe d'une valeur de consigne de couple prédéterminée ( 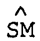 ).

4. Procédé selon la revendication 1 ou 2, dans lequel on ne détermine pas le paramètre de système résistance de stator (R̂ₛ) avec une relation analytique mais avec les étapes de procédé suivantes :
a) application d'une valeur de consigne de couple prédéterminée ( 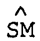 ) à la machine polyphasée (DM),
b) transformation d'un vecteur spatial réel de courant statorique ( 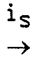 ) déterminé à partir des courants statoriques mesurés (i_{b}, i_{c}) et d'un vecteur spatial de modèle de courant statorique déterminé ( 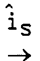 ) dans un système de référence complexe à orientation de champ au moyen d'un vecteur spatial de référence complexe conjugué ( 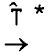 ),
c) division de ces vecteurs réel et de modèle de courant statorique transformés ( 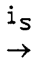 , 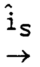 ) à chaque fois en une partie réelle et une partie imaginaire (BG, 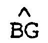 , WG, 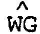 ),
d) détermination d'un écart de régulation (Δ∥) pour le réglage du paramètre de système résistance de stator (R̂ₛ) par une comparaison des parties réelles déterminées (BG, 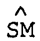 ) de ces vecteurs réel et de modèle de courant statorique transformés ( 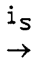 , 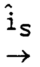 ), et
e) utilisation de cet écart de régulation (Δ∥) pour le réglage du paramètre de système résistance de stator (R̂ₛ) de telle sorte que l'écart de régulation déterminé (Δ∥) s'annule.

5. Procédé selon l'une des revendications 1 à 4 avec une traction qui comporte plusieurs machines polyphasées (DM) sans capteur et à orientation de champ, dans lequel on applique la valeur de consigne de couple prédéterminée ( 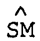 ) successivement aux machines polyphasées (DM) les unes après les autres.

6. Procédé selon la revendication 5, dans lequel on applique respectivement à deux machines polyphasées (DM) une valeur de consigne de couple prédéterminée ( 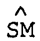 ) opposée.

7. Procédé selon l'une des revendications 1 à 6, dans lequel on utilise comme valeur de consigne de couple ( 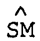 ) une grandeur alternative sans composante continue.

8. Dispositif pour la mise en oeuvre du procédé selon la revendication 1 comportant une commande de système (36), un traitement de signal (2) qui contient entre autres un modèle de machine complet et un modulateur, un élément de mesure (6) avec un convertisseur de coordonnées (8) branché du côté aval, deux éléments multiplicateurs complexes (18, 20) et deux comparateurs (24, 30), dans lequel une sortie du traitement de signal (2) à laquelle se trouve un vecteur spatial de référence complexe conjugué ( 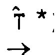 ) est reliée à chaque fois à une entrée des éléments multiplicateurs complexes (18, 20), dans lequel la sortie du convertisseur de données (8) est reliée à une deuxième entrée du deuxième élément multiplicateur (20), dans lequel une sortie du traitement de signal (2) à laquelle se trouve un vecteur spatial de modèle de courant statorique déterminé ( 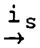 ) est reliée à une deuxième entrée du premier élément multiplicateur (18) et dans lequel les sorties imaginaires des deux éléments multiplicateurs (18, 20) sont reliées aux entrées du premier comparateur (24) et leurs sorties réelles aux entrées du deuxième comparateur (30), **caractérisé par** le fait que la sortie du convertisseur de coordonnées (8) est reliée en outre au moyen d'un interrupteur (46) au traitement de signal (2), que les sorties imaginaires des deux éléments multiplicateurs complexes (18, 20) sont reliées au moyen d'un dispositif (64) pour la détermination d'un écart de régulation (|Δ⊥|, ω̂') à un régulateur (44) qui est relié en sortie à une entrée de paramètre pour le paramètre de système résistance de rotor (R̂ᵣ) du traitement de signal (2) et que ce dispositif (64) et le traitement de signal (2) sont reliés à la commande de système (36).

9. Dispositif selon la revendication 8, **caractérisé par** le fait que le dispositif (64) pour la détermination de l'écart de régulation (|Δ⊥|) comporte deux interrupteurs (48, 50), deux dispositifs de formation de valeur absolue (38, 40) et un comparateur (42), dans lequel ces dispositifs de formation de valeur absolue (38, 40) sont reliés en entrée à chaque fois à un interrupteur (48, 50) et en sortie à une entrée du comparateur (42) à la sortie duquel se trouve l'écart de régulation déterminé (|Δ⊥|) et dans lequel les interrupteurs (48, 50) sont reliés en entrée aux sorties imaginaires des éléments multiplicateurs complexes (18, 20).

10. Dispositif selon la revendication 8, **caractérisé par** le fait que le dispositif (64) pour la détermination de l'écart de régulation (ω̂') comporte un comparateur (24), un régulateur de compensation (22) et un multiplicateur (66), dans lequel le régulateur de compensation (22) est relié en entrée à la sortie du premier comparateur (24) et en sortie au multiplicateur (66) à la deuxième entrée duquel se trouve un signal de signe (sign 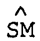 ) d'une valeur de consigne de couple prédéterminée ( 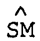 ) et dans lequel le comparateur (24) est relié en entrée aux sorties des multiplicateurs complexes (18, 20).

11. Dispositif selon l'une des revendications 8 ou 9, **caractérisé par** le fait que les sorties réelles des deux éléments multiplicateurs complexes (18, 20) sont reliées à chaque fois par l'intermédiaire d'un interrupteur (54, 56) à un comparateur (58), que ce comparateur (58) est relié en sortie au moyen d'un régulateur (52) à une entrée de paramètre pour le paramètre de système résistance de stator (R̂ₛ) du traitement de signal (2) et que les interrupteurs (54, 56) sont reliés à la commande de système (36).

12. Dispositif selon la revendication 11, **caractérisé par** le fait que le comparateur (58) peut être relié en sortie au moyen d'un commutateur (60) à un régulateur de compensation (32) qui est relié en sortie à l'entrée de paramètre pour le paramètre de système résistance de stator (R̂ₛ).

13. Dispositif selon l'une des revendications 8, 9, 10, 11 ou 12, **caractérisé par** le fait qu'il est prévu comme régulateur (44, 52) un régulateur par intégration.

14. Dispositif selon l'une des revendications 8, 9, 10, 11 ou 12, **caractérisé par** le fait qu'il est prévu comme régulateur (44, 52) un régulateur proportionnel et par intégration.

15. Dispositif selon l'une des revendications 8 à 14, **caractérisé par** le fait que ce dispositif et le traitement de signal (2) forment une unité.
